# EUROPÄISCHE PATENTSCHRIFT

(11) **EP 4 127 747 B1**
(45) Veröffentlichungstag und Bekanntmachung des Hinweises auf die Patenterteilung: **19.02.2025**
(21) Anmeldenummer: 20718536.4
(22) Anmeldetag: 24.03.2020
(51) Int. Cl.: G01R 31/34

(54) **VERFAHREN UND EINRICHTUNG ZUR DETEKTION VON INFOLGE STATISCHER AUFLADUNG VON ROTIERENDEN MASCHINEN- / ANLAGENTEILEN IN EINEM WÄLZLAGER AUFTRETENDEN ELEKTRISCHEN STROMIMPULSEN**
METHOD AND DEVICE FOR DETECTING ELECTRICAL CURRENT PULSES OCCURRING IN A ROLLING BEARING AS A RESULT OF STATIC CHARGING OF ROTATING MACHINE/SYSTEM PARTS
PROCÉDÉ ET DISPOSITIF DE DÉTECTION D'IMPULSIONS DE COURANT ÉLECTRIQUE SE PRODUISANT DANS UN PALIER À ROULEMENT SOUS L'EFFET DE CHARGES STATIQUES DE PARTIES ROTATIVES DE MACHINE/SYSTÈME

(43) Veröffentlichungstag der Anmeldung: 08.02.2023
(73) Patentinhaber: Schaeffler Technologies AG & Co. KG, 91074 Herzogenaurach (DE)
(72) Erfinder: REINERS, Harald, 52070 Aachen (DE)
(86) Internationale Anmeldenummer: PCT/DE2020/100230
(87) Internationale Veröffentlichungsnummer: WO 2021/190677

(56) Entgegenhaltungen:
- EP-A1- 1 835 598
- EP-A1- 3 570 052
- EP-B1- 1 835 598
- EP-B1- 2 539 680
- US-A- 4 814 699

## Beschreibung

Die Erfindung betrifft ein Verfahren sowie eine Einrichtung zur Detektion von infolge statischer Aufladung von rotierenden Maschinen- oder Anlagenteilen in einem Wälzlager zwischen Lageraußenring, Wälzkörpern und Lagerinnenring auftretenden elektrischen Stromimpulsen. Weiterhin betrifft die Erfindung auch ein dieses Verfahren verkörperndes Computerprogrammprodukt sowie als speziellen Anwendungsfall eine Windenergieanlage, bei welcher die erfindungsgemäße Lösung implementiert ist.

Das Anwendungsgebiet der Erfindung erstreckt sich prinzipiell auf alle rotierenden Maschinen- oder Anlagenteile, die mittels Wälzlagerung an einer ortsfesten Tragstruktur gelagert sind. Als spezielles Einsatzgebiet sei jedoch die Windenergieanlagentechnik hervorgehoben, bei welcher insbesondere schädliche Stromdurchgänge durch die Rotorlagerung, welche durch eine statische Aufladung der Rotorblätter entstehen, zu einer Lagerschädigung führen können. Untersuchungen haben ergeben, dass derartige von statischer Aufladung verursachte Stromdurchgänge einen wesentlichen Einflussfaktor für die Entstehung von sogenannten WEC's (White Etching Cracks) bilden. Unter WEC werden gewöhnlich Risse im Mikrogefüge des Lagerstahls verstanden, welches lokale weiß anätzende Bereiche aufweist, die aus feinstem, nanokristallinem, carbidfreiem Ferrit oder Ferrit mit einer sehr feinen Verteilung von Carbiden bestehen. Die weiß anätzenden Bereiche um die Risse herum sind dabei härter als das diese umgebende, nicht betroffene Mikrogefüge des Lagerstahls und führen im Laufe der Zeit zur Lagerschädigung. Daher ist eine zuverlässige Detektion von infolge statischer Aufladung in der Lagerung auftretenden elektrischen Stromflüssen eine Voraussetzung dafür, den Lagerzustand zu überwachen und gegebenenfalls rechtzeitig Wartungsmaßnahmen einzuleiten.

Die EP 3 570 052 A1 beschreibt ein Verfahren zur Messung eines gepulsten hochfrequenten Ereignissignals, insbesondere einer Teilentladung, in einer elektrischen rotierenden Maschine, wobei das Ereignissignal aus einem hochfrequenten elektromagnetischen Feld mit Hilfe eines Sensors während des Betriebes ausgekoppelt wird.

EP 1 835 598 A1 beschreibt ein Verfahren zum Anzeigen eines Auftretens elektrischer Entladung in einem Schmiermittel zwischen einem Wälzkörper und einer Laufbahn in einem Lager eines elektrischen Antriebssystems.

Die US 4 814 699 A beschreibt ein Verfahren zur Teilentladungserfassung und Abreißfunkenmessung bei dynamoelektrischen Hochspannungsmaschinen zur Betriebsüberwachung des Isolationszustandes der Ständerwicklung und der angeschlossenen elektrischen Ableitungen bei Turbogeneratoren.

Die EP 2 539 680 B1 offenbart eine technische Lösung zur Detektion einer Schädigung von Wälzlagern, allerdings im nicht gattungsgemäßen Kontext von umrichtergespeisten elektrischen Maschinen. Hierzu ist eine elektrische Maschine an einem Umrichter angeschlossen. Zur Erfassung eines das Wälzlager passierenden Entladungsereignisses erfolgt eine Messung in zwei unterschiedlichen Frequenzbändern, wobei im ein- bis mehrstelligen Megaherzbereich eines Frequenzbandes die Energie des Entladungsereignisses bestimmt wird und in einem anderen Frequenzband oberhalb einem Gigaherz nach einem Koinzidentenereignis gesucht wird, wobei das Koinzidentenereignis zeigt, dass von einem schädlichen Lagerstromereignis ausgegangen werden muss. Diese technische Lösung zur Detektion von Lagerströmen erweist sich daher als recht anwendungsspezifisch und ist insoweit schwer auf andere Anwendungsgebiete übertragbar.

Es ist die Aufgabe der vorliegenden Erfindung ein Verfahren sowie eine Einrichtung zur Detektion von speziell infolge statischer Aufladung von rotierenden Maschinen- oder Anlagenteilen durch ein Wälz- oder Gleitlager fließende Stromimpulse zu schaffen, welche mit einfachen technischen Mitteln zuverlässig erfasst und bewertet werden können.

Die Aufgabe wird verfahrenstechnisch durch Anspruch 1 gelöst. Hinsichtlich einer hiermit korrespondierenden Einrichtung wird auf Anspruch 4 verwiesen. Den speziellen Anwendungsfall im Rahmen einer Windenergieanlage gibt Anspruch 7 an und der Anspruch 8 widmet sich einem das Verfahren verkörpernden Computerprogrammprodukt. Rückbezogene abhängige Ansprüche geben vorteilhafte Weiterbildungen der Erfindung wieder.

Die Erfindung schließt die verfahrenstechnische Lehre ein, dass zur Detektion der charakteristischen elektrischen Stromimpulse die folgenden Schritte durchgeführt werden:
- Empfangen von elektromagnetischen Funkwellen, die infolge der charakteristischen elektrischen Stromimpulse im Frequenzbereich oberhalb 50 MHz emittiert werden;
- Aufbereitung des empfangenen Signals durch eine Signalverarbeitung zur Extraktion der hierin enthaltenen Stromimpulsereignisse, umfassend Filterung;
- Analyse des zeitlichen Verlaufs der Stromimpulsereignisse zur Zustandsüberwachung des Wälzlagers oder Gleitlagers.

Die erfindungsgemäße Lösung basiert auf der Erkenntnis, dass die speziell infolge von statischer Aufladung rotierender Maschinen- oder Anlagenteile erzeugten charakteristischen elektrischen Stromimpulse Funkwellen in einem hierfür typischen Frequenzbereich erzeugen, welche im Signalverlauf als Impuls mit recht schneller Abklingphase sichtbar werden. Durch diese Stromimpulsereignisse lassen sich die interessierenden Stromimpulsereignisse im Frequenzspektrum identifizieren.

Vorzugsweise wird zur Extraktion der Stromimpulsereignisse, also der Aufbereitung des empfangenen Signals, eine Hüllkurvenbildung verwendet, welche nach einer bevorzugten Ausführungsform eine Hochpassfilterung des empfangenen Signals mit anschließender Gleichrichtung und nachfolgender Tiefpassfilterung umfasst. Dies bildet die Voraussetzung dafür, das aufbereitete Signal durch einfache Integration, aus einer Ermittlung der Fläche pro Sekunde als Messgröße, zu analysieren, um die auftretenden Stromimpulsereignisse zu quantifizieren, also einer Bewertung zugänglich zu machen.

Alternativ hierzu ist es auch möglich, dass die Analyse durch eine Zählung der Anzahl der Stromimpulsereignisse des aufbereiteten Signals pro Zeiteinheit durchgeführt wird, um die auftretenden Stromimpulsereignisse zu quantifizieren. Hierbei wird also die Anzahl pro Sekunde als Messgröße für die anschließende Bewertung herangezogen.

Das erfindungsgemäße Verfahren, welches insbesondere eine spezielle Signalverarbeitung umfasst, lässt sich in eine elektronische Einrichtung implementieren, welche vorzugsweise aus einer Empfangseinheit, einer Signalaufbereitungseinheit und einer Analyseeinheit besteht. Diese Komponenten lassen sich beispielsweise in einer Detektionseinrichtung unterbringen, die eine Schnittstelle zur Verbindung mit einem Anlagen-Zustandsüberwachungssystem oder einer Anlagensteuerung aufweist. So können die gewonnenen Messgrößen beispielsweise in Form eines analogen Signals zur Weiterverarbeitung und Auswertung an ein Zustandsüberwachungssystem (Condition Monitoring System) übergeben werden. Alternativ oder ergänzend hierzu ist es auch denkbar, eine eigene Detektionseinrichtung als separates Gerät mit vorzugsweise integrierter Alarmierungseinheit zu schaffen. Die Alarmierungseinheit könnte dabei beispielsweise optische oder akustische Signale aussenden, um das Erreichen eines kritischen Zustands für die Lagerung zu signalisieren. Natürlich lässt sich eine Messgrößenweitergabe an eine übergeordnete Instanz auch in ein solches lokales Gerät integrieren. Das lokale Gerät kann beispielsweise auch im Bereich innerhalb des Lagergehäuses oder in einem Getriebe verbaut werden und ist hierdurch gegen äußere elektromagnetische Fremdeinstrahlung störgesichert.

Gemäß einem bevorzugten Ausführungsbeispiel lässt sich die erfindungsgegenständliche Einrichtung zur Detektion von infolge statischer Aufladung in einer Lagerung auftretenden charakteristischen Stromflüssen in einer Windenergieanlage integrieren. Denn die Rotorblätter einer Windenergieanlage sind insbesondere durch Wettereinflüsse einer erheblichen statischen Aufladung ausgesetzt, welche über die Drehlagerung abgeleitet wird. Die hierbei auftretenden charakteristischen Stromflüsse können zu Stromdurchschlägen und Blitzentladungen im Lagerbereich führen.

Ferner sei darauf hingewiesen, dass sich die erfindungsgemäße Lösung auch durch ein Computerprogrammprodukt verwirklichen lässt, das Programmcodemittel zur Durchführung des Verfahrens auf einer kombinierten mikroprozessorgesteuerten Signalaufbereitungseinheit mit Analyseeinheit abläuft oder auf einem computerlesbaren Datenträger speicherbar ist.

Weitere die Erfindung verbessernde Maßnahmen werden nachstehend gemeinsam mit der Beschreibung eines bevorzugten Ausführungsbeispiels der Erfindung anhand der Figuren näher dargestellt. Es zeigt:
- Figur 1: eine schematische Blockschaltbilddarstellung einer in einer Windenergieanlage implementierten Einrichtung zur Detektion von infolge statischer Aufladung des Rotors durch ein Wälzlager fließende elektrische Stromimpulse, und
- Figur 2: eine schematische Darstellung einer Hüllkurvenbildung zur Aufbereitung des empfangenen Signals als Voraussetzung für die Signalanalyse.

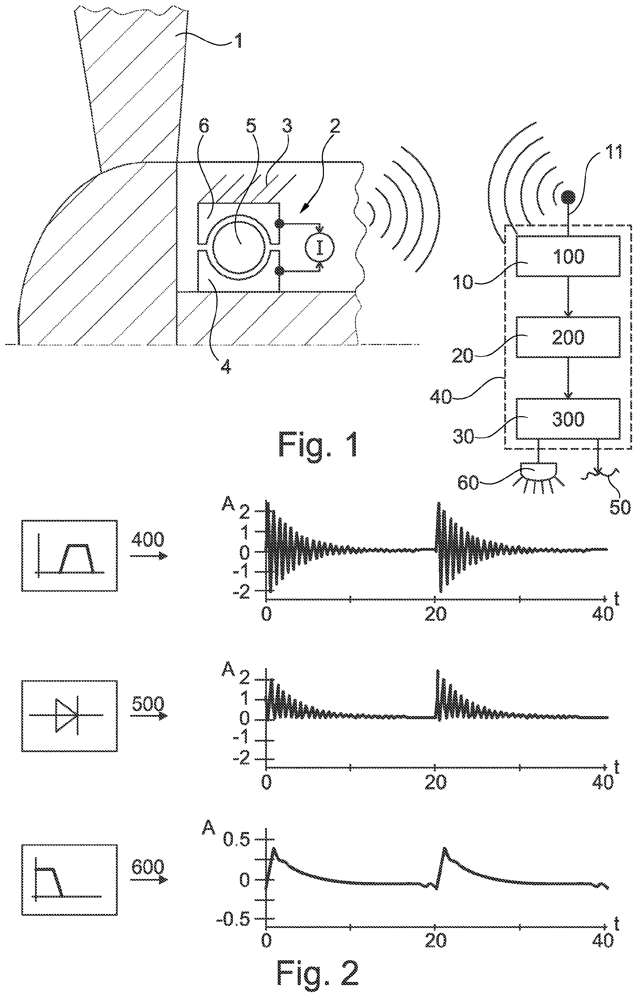

Gemäß Fig. 1 weist eine hier nur schematisch dargestellte Windenergieanlage einen Rotor 1 auf, der über ein als Rotorwellenlager ausgebildetes Wälzlager 2 drehbar an einer Tragstruktur 3 einer - nicht weiter im Detail dargestellten - Kabine auf einem Turm der Windenergieanlage gelagert ist.

Die Rotorblätter des Rotors 1 erfahren während des Betriebes eine statische Aufladung, welche durch das Wälzlager 2, hier vom Lagerinnenring 4 über die Wälzkörper 5 hinweg zum Lageraußenring 6 in die geerdete Tragstruktur 3 abfließt. Hierdurch werden Entladungen im Wälzlager 2 als elektromagnetische Funkwellen emittiert, welche in einem typischen Frequenzbereich oberhalb 50 MHz liegen.

Eine im Empfangsbereich, also ortsnah zum Wälzlager 2, installierte Empfangseinheit 10 dient dem Empfangen 100 der elektromagnetischen Funkwellen per hieran angebrachter Antenne 11. Eine nachgeschaltete Signalaufbereitungseinheit 20 dient der Aufbereitung 200 des empfangenen Signals durch eine Signalverarbeitung zur Extraktion der hierin enthaltenen Stromimpulsereignisse, welche bei diesem Ausführungsbeispiel insbesondere eine Hüllkurvenbildung umfasst. Eine nachfolgende Analyseeinheit 30 dient einer Analyse 300 des zeitlichen Verlaufs der Stromimpulsereignisse zur Zustandsüberwachung des Wälzlagers 2.

Die Empfangseinheit 10 ist mit der Signalaufbereitungseinheit 20 und der Analyseeinheit 30 in einer gemeinsamen Detektionseinrichtung 40 untergebracht, welche über eine Datenübertragungs-Schnittstelle 50 an ein - nicht weiter dargestellten - Anlagen-Zustandsüberwachungssystem angeschlossen ist. Ferner ist in die Detektionseinrichtung 50 auch eine Alarmierungseinheit 60 mit integriert, welche als lokale optische Anzeige eines kritischen Zustands dient.

Die Fig. 2 illustriert die im Zuge der Signal-Aufbereitung der empfangenen elektromagnetischen Funkwellen vorzugsweise durchgeführte Hüllkurvenbildung. Demnach erfolgt ausgehend vom empfangenen Signal zunächst eine Hochpassfilterung 400, um irrelevante Signalanteile zu eliminieren. Durch eine anschließende Gleichrichtung 500 werden die Unterwellen des Signals weggeschnitten. Schließlich sorgt eine Tiefpassfilterung 600 für eine Formung von Flächeninhalten zwischen dem Kurvenverlauf und der Abszissenachse. Dies bildet die Voraussetzung für eine vorzugsweise spätere Integration, um die Fläche pro Zeiteinheit als Messgröße für die aufgetretenen Stromimpulsereignisse heranzuziehen.

Die Erfindung ist nicht beschränkt auf das vorstehend beschriebene bevorzugte Ausführungsbeispiel. Es sind vielmehr auch Abwandlungen hiervon denkbar, welche vom Schutzbereich der nachfolgenden Ansprüche mit umfasst sind. Insbesondere ist die erfindungsgemäße Lösung nicht allein auf Windenergieanlagen anwendbar, sondern allgemein auf nicht leitungsgebundene Stromentladungs-Szenarien. Ferner sei darauf hingewiesen, dass die Signalaufbereitung zur Messgrößengewinnung nicht allein auf eine Hüllkurvenbildung des empfangenen Funksignals festgelegt ist. Es können zu diesem Zweck alternativ auch Samplingverfahren oder andere geeignete Analysen genutzt werden.

### Bezugszeichenliste

- 1: Rotor
- 2: Wälzlager
- 3: Tragstruktur
- 4: Lagerinnenring
- 5: Wälzkörper
- 6: Lageraußenring

- 10: Empfangseinheit
- 11: Antenne
- 20: Signalaufbereitungseinheit
- 30: Analyseeinheit
- 40: Detektionseinrichtung
- 50: Datenübertragungs-Schnittstelle
- 60: Alarmierungseinheit

- 100: Empfangen elektromagnetischer Funkwellen
- 200: Aufbereitung des empfangenen Signals
- 300: Analyse hinsichtlich Stromimpulsereignissen
- 400: Hochpassfilterung
- 500: Gleichrichtung
- 600: Tiefpassfilterung

- I: Stromfluss
- A: Amplitude
- t: Zeit

## Patentansprüche

1. Verfahren zur Detektion von infolge statischer Aufladung von rotierenden Maschinen- oder Anlagenteilen durch ein Wälzlager (2) oder Gleitlager fließende charakteristische elektrische Stromimpulse, umfassend die folgenden Schritte:
- Empfangen (100) von elektromagnetischen Funkwellen, die infolge der charakteristischen elektrischen Stromimpulse im Frequenzbereich oberhalb 50 MHz emittiert werden;
**gekennzeichnet durch:**
- Aufbereitung (200) des empfangenden Signals durch eine Signalverarbeitung zur Extraktion der hierin enthaltenen Stromimpulsereignisse, umfassend Filterung, wobei die Aufbereitung (200) des empfangenden Signals durch eine Hüllkurvenbildung erfolgt, die eine Hochpassfilterung (400) des empfangenden Signals mit anschließender Gleichrichtung (500) und nachfolgender Tiefpassfilterung (600) umfasst,
- Analyse (300) des zeitlichen Verlaufs der Stromimpulsereignisse zur Zustandsüberwachung des Wälzlagers (2) oder Gleitlagers, wobei die Analyse (300) eine Abklingphase in einem Signalverlauf der Funkwellen ermittelt.

2. Verfahren nach Anspruch 1,
**dadurch gekennzeichnet, dass** die Analyse (300) eine Integration des durch die Tiefpassfilterung gewonnenen aufbereiteten Signals umfasst, um die aufgetretenen Stromimpulsereignisse zu quantifizieren.

3. Verfahren nach Anspruch 1,
**dadurch gekennzeichnet, dass** die Analyse (300) eine Zählung der Anzahl der Stromimpulsereignisse des aufbereiteten Signals pro Zeiteinheit umfasst, um die aufgetretenen Stromimpulsereignisse zu quantifizieren.

4. Einrichtung zur Detektion von infolge statischer Aufladung von rotierenden Maschinen- oder Anlagenteilen durch ein Wälzlager (2) oder Gleitlager fließende charakteristische elektrische Stromimpulse, umfassend:
- eine Empfangseinheit (10) zum Empfangen von elektromagnetischen Funkwellen, die infolge der charakteristischen elektrischen Stromimpulse im Frequenzbereich oberhalb 50 MHz emittiert werden;
**gekennzeichnet durch:**
- eine Signalaufbereitungseinheit (20) zur Aufbereitung des empfangenden Signals durch eine Signalverarbeitung zur Extraktion der hierin enthaltenen Stromimpulsereignisse, umfassend Filterung, wobei die Aufbereitung (200) des empfangenden Signals durch eine Hüllkurvenbildung erfolgt, die eine Hochpassfilterung (400) des empfangenden Signals mit anschließender Gleichrichtung (500) und nachfolgender Tiefpassfilterung (600) umfasst;
- eine Analyseeinheit (30) zur Analyse des zeitlichen Verlaufs der Stromimpulsereignisse zur Zustandsüberwachung des Wälzlagers (2) oder Gleitlagers, wobei die Analyse (300) eine Abklingphase in einem Signalverlauf der Funkwellen ermittelt.

5. Einrichtung nach Anspruch 4,
**dadurch gekennzeichnet, dass** die Empfangseinheit (10), die Signalaufbereitungseinheit (20) und die Analyseeinheit (30) in einer Detektionseinrichtung (40) untergebracht sind, die eine Datenübertragungs-Schnittstelle (50) zur Verbindung mit einem Anlagen-Zustandsüberwachungssystem oder einer Anlagensteuerung aufweist.

6. Einrichtung nach Anspruch 5,
**dadurch gekennzeichnet, dass** die Detektionseinrichtung (50) als ein separates Gerät mit integrierter lokaler Alarmierungseinheit (60) ausgebildet ist.

7. Windenergieanlage mit einem Rotor (1) als rotierendes Maschinen- oder Anlagenteil, das über mindestens ein als Rotorlager ausgebildetes Wälzlager (2) oder Gleitlager drehbar an einer Tragstruktur (3) gelagert ist, wobei ortsnah zum Wälzlager (2) oder Gleitlager eine Einrichtung zur Detektion von infolge statischer Aufladung des Rotors (1) in dem mindestens einen Wälzlager (2) oder Gleitlager zwischen Lageraußenring (6) und Lagerinnenring (4) auftretenden charakteristischen Stromflüssen nach einem der Ansprüche 4 bis 6 angeordnet ist.

8. Computerprogrammprodukt mit Programmcodemittel zur Durchführung des Verfahrens nach einem der Ansprüche 1 bis 3, wenn das Computerprogrammprodukt auf einer kombinierten Signalaufbereitungseinheit (200) mit Analyseeinheit (300) einer Einrichtung nach einem der Ansprüche 4 bis 6 abläuft.

## Claims

1. A method for detecting characteristic electrical current pulses flowing through a rolling bearing (2) or plain bearing as a result of static charging of rotating machine or system parts, comprising the following steps:
- receiving (100) electromagnetic radio waves emitted as a result of the characteristic electrical current pulses in the frequency range above 50 MHz;
**characterised by:**
- processing (200) of the received signal by means of signal processing for extracting the current pulse events contained therein, comprising filtering, wherein the processing (200) of the received signal is carried out by envelope formation which comprises a high-pass filtering (400) of the received signal with subsequent rectification (500) and subsequent low-pass filtering (600);
- analysis (300) of the temporal course of the current pulse events for monitoring the state of the rolling bearing (2) or plain bearing, wherein the analysis (300) determines a fading phase in a signal course of the radio waves.

2. The method according to claim 1,
**characterised in that** the analysis (300) comprises an integration of the processed signal obtained by the low-pass filtering in order to quantify the current pulse events that have occurred.

3. The method according to claim 1,
**characterised in that** the analysis (300) comprises counting the number of current pulse events of the processed signal per unit of time in order to quantify the current pulse events that have occurred.

4. A device for detecting characteristic electrical current pulses flowing through a rolling bearing (2) or plain bearing as a result of static charging of rotating machine or system parts, comprising:
- a receiving unit (10) for receiving electromagnetic radio waves emitted as a result of the characteristic electrical current pulses in the frequency range above 50 MHz;
**characterised by:**
- a signal processing unit (20) for processing the received signal by means of signal processing for extracting the current pulse events contained therein, comprising filtering, wherein the processing (200) of the received signal is carried out by envelope formation which comprises a high-pass filtering (400) of the received signal with subsequent rectification (500) and subsequent low-pass filtering (600);
- an analysis unit (30) for analysis of the temporal course of the current pulse events for monitoring the state of the rolling bearing (2) or plain bearing, wherein the analysis (300) determines a fading phase in a signal course of the radio waves.

5. The device according to claim 4,
**characterised in that** the receiving unit (10), the signal processing unit (20) and the analysis unit (30) are accommodated in a detection device (40) which has a data transmission interface (50) for connection with a system state monitoring system or a system control system.

6. The device according to claim 5,
**characterised in that** the detection device (50) is designed as a separate device with an integrated local alarm unit (60).

7. A wind energy system having a rotor (1) as a rotating machine or system part, which is rotatably mounted on a support structure (3) via at least one rolling bearing (2) or plain bearing designed as a rotor bearing, wherein a device according to one of claims 4 to 6 for detecting characteristic current flows occurring as a result of static charging of the rotor (1) in the at least one rolling bearing (2) or plain bearing between the bearing outer ring (6) and the bearing inner ring (4) is arranged close to the rolling bearing (2) or plain bearing.

8. A computer program product having program code means for carrying out the method according to one of claims 1 to 3, when the computer program product runs on a combined signal processing unit (200) with analysis unit (300) of a device according to one of claims 4 to 6.

## Revendications

1. Procédé de détection d'impulsions de courant électrique caractéristiques circulant dans un palier à roulement (2) ou un palier lisse sous l'effet de charges statiques de parties rotatives de machine ou système, comprenant les étapes suivantes :
- la réception (100) d'ondes radio électromagnétiques qui sont émises sous l'effet des impulsions de courant électrique caractéristiques dans la plage de fréquences supérieures à 50 MHz ;
**caractérisé par :**
- la préparation (200) du signal reçu par traitement du signal pour extraire les événements d'impulsions de courant contenus dans celui-ci, comprenant un filtrage, la préparation (200) du signal reçu étant effectuée par une formation d'enveloppe, qui comprend un filtrage passe-haut (400) du signal reçu avec une rectification (500) ultérieure et un filtrage passe-bas (600) ultérieur ;
- l'analyse (300) de l'évolution temporelle des événements d'impulsions de courant pour surveiller l'état du palier à roulement (2) ou du palier lisse, l'analyse (300) déterminant une phase de décroissance dans l'évolution de signal des ondes radio.

2. Procédé selon la revendication 1,
**caractérisé en ce que** l'analyse (300) comprend une intégration du signal traité obtenu par filtrage passe-bas afin de quantifier les événements d'impulsions de courant qui se sont produits.

3. Procédé selon la revendication 1,
**caractérisé en ce que** l'analyse (300) comprend un comptage du nombre d'événements d'impulsions de courant du signal traité par unité de temps pour quantifier les événements d'impulsions de courant qui se sont produits.

4. Dispositif de détection d'impulsions de courant électrique caractéristiques circulant dans un palier à roulement (2) ou un palier lisse sous l'effet de charges statiques de parties rotatives de machine ou système, comprenant :
- une unité de réception (10) pour recevoir des ondes radio électromagnétiques qui sont émises sous l'effet des impulsions de courant électrique caractéristiques dans la plage de fréquences supérieures à 50 MHz ;
**caractérisé par :**
- une unité de traitement de signal (20) pour traiter le signal reçu par traitement de signal pour extraire les événements d'impulsions de courant contenus dans celui-ci, comprenant un filtrage, le traitement (200) du signal reçu étant effectué par formation d'enveloppe, qui comprend un filtrage passe-haut (400) du signal reçu avec rectification (500) ultérieure et filtrage passe-bas (600) ultérieur ;
- une unité d'analyse (30) pour analyser l'évolution temporelle des événements d'impulsions de courant pour surveiller l'état du palier à roulement (2) ou du palier lisse, l'analyse (300) déterminant une phase de décroissance dans l'évolution de signal des ondes radio.

5. Dispositif selon la revendication 4,
**caractérisé en ce que** l'unité de réception (10), l'unité de traitement de signal (20) et l'unité d'analyse (30) sont logées dans un dispositif de détection (40) qui présente une interface de transmission de données (50) pour la connexion à un système de surveillance de l'état du système ou à une commande du système.

6. Dispositif selon la revendication 5,
**caractérisé en ce que** le dispositif de détection (50) est conçu comme un appareil séparé avec une unité d'alarme locale intégrée (60).

7. Système d'éolienne comportant un rotor (1) en tant que partie rotative de machine ou système, qui est montée rotative sur une structure de support (3) par l'intermédiaire d'au moins un palier à roulement (2) ou un palier lisse conçu comme palier de rotor, un dispositif de détection, à proximité du palier à roulement (2) ou du palier lisse, des flux de courant caractéristiques se produisant sous l'effet de charges statiques du rotor (1) dans l'au moins un palier à roulement (2) ou palier lisse étant agencé entre la bague extérieure (6) du palier et la bague intérieure (4) du palier selon l'une des revendications 4 à 6.

8. Produit programme d'ordinateur comportant des moyens de code de programme pour mettre en œuvre le procédé selon l'une des revendications 1 à 3, lorsque le produit programme d'ordinateur s'exécute sur une unité de traitement de signal (200) combinée avec une unité d'analyse (300) d'un dispositif selon l'une des revendications 4 à 6.
